(19) **Europäisches Patentamt European Patent Office Office européen des brevets**

(11) **EP 1 420 300 B1**

(12) **EUROPEAN PATENT SPECIFICATION**

(45) Date of publication and mention
of the grant of the patent:
**29.07.2015  Bulletin 2015/31**

(51) Int Cl.:
*G03F 7/20* (2006.01)     *G03F 9/00* (2006.01)

(21) Application number: **03257072.3**

(22) Date of filing: **10.11.2003**

(54) **Lithographic apparatus and device manufacturing method**

Lithographischer Apparat und Verfahren zur Herstellung einer Vorrichtung

Appareil lithographique et méthode de fabrication d'un dispositif

(84) Designated Contracting States:
**DE FR GB IT NL**

(30) Priority: **12.11.2002  EP 02257822
11.06.2003  EP 03253692**

(43) Date of publication of application:
**19.05.2004  Bulletin 2004/21**

(73) Proprietor: **ASML Netherlands B.V.
5504 DR  Veldhoven (NL)**

(72) Inventors:
• **Lof, Joeri
5616 BW Eindhoven (NL)**
• **De Smit, Joannes Theodoor
5642 NB Eindhoven (NL)**
• **Ritsema, Roelof Aeilko Siebrand
5615 RK Eindhoven (NL)**
• **Simon, Klaus
5655 CP Eindhoven (NL)**
• **Modderman, Theodorus Marinus
5672 HW Nuenen (NL)**
• **Mulkens, Johannes Catharinus Hubertus
6211 LP Maastricht (NL)**

• **Meijer, Hendricus Johannes, Maria
5506 CA Veldhoven (NL)**
• **Loopstra, Erik Roelof
5591 BA Heeze (NL)**

(74) Representative: **Corcoran, Gregory Martin Mason
et al
ASML Netherlands B.V.
Corporate Intellectual Property
P.O. Box 324
5500 AH Veldhoven (NL)**

(56) References cited:
**EP-A- 1 477 856     EP-A- 1 571 696
EP-A- 1 628 329     US-B1- 6 191 429**

• **PATENT ABSTRACTS OF JAPAN vol. 1999, no. 03, 31 March 1999 (1999-03-31) -& JP 10 340846 A (NIKON CORP), 22 December 1998 (1998-12-22)**
• **PATENT ABSTRACTS OF JAPAN vol. 1999, no. 02, 26 February 1999 (1999-02-26) & JP 10 303114 A (NIKON CORP), 13 November 1998 (1998-11-13)**
• **PATENT ABSTRACTS OF JAPAN vol. 1999, no. 12, 29 October 1999 (1999-10-29) & JP 11 176727 A (NIKON CORP), 2 July 1999 (1999-07-02)**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

The present invention relates to a lithographic projection apparatus comprising:

- a radiation system for providing a projection beam of radiation;
- a support structure for supporting patterning means, the patterning means serving to pattern the projection beam according to a desired pattern;
- a substrate table for holding a substrate;
- a projection system for projecting the patterned beam onto a target portion of the substrate;
- a seal member positioned below and surrounding a final element of the projection system, the seal member comprising a liquid supply system for filling a space between the final element of said projection system and said substrate with a liquid; and
- a measurement system for measuring locations of points on said substrate and generating a map of said points on said substrate.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:

- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired.

A programmable mirror array. One example of such a device is a matrix-addressable surface having a viscoelastic control layer and a reflective surface.

- The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-addressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the patterning means can comprise one or more • programmable mirror arrays. More information on mirror arrays as here referred to can be gleaned, for example, from United States Patents US 5,296,891 and US 5,523,193, and PCT patent applications WO 98/38597 and WO 98/33096. In the case of a programmable mirror array, the said support structure may be embodied as a frame or table, for example, which may be fixed or movable as required.

- A programmable LCD array. An example of such a construction is given in United States Patent US 5,229,872. As above, the support structure in this case may be embodied as a frame or table, for example, which may be fixed or movable as required.

For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (e.g. comprising one or more dies) on a substrate (silicon wafer. LCD, mask etc) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper. In an alternative apparatus - commonly referred to as a step-and-scan apparatus - each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791.

The lithographic industry is constantly trying to reduce feature sizes on silicon substrates in order to manufacture ever more complex integrated circuits. The feature sizes are limited by the effect of diffraction and thus the revolution of a particular system of numeral aperture NA using a wavelength $\lambda$ is:

$$W = k \frac{\lambda}{NA}$$

where k is a pre-factor. The numerical aperture NA is n sin θ where n is the refractive index of the transmissive substance.

Hence to decrease the resolution, the wavelength can either be reduced or the numerical aperture increased. It has been proposed to immerse the substrate in a liquid having a relatively high refractive index, e.g. water, so as to fill a space between the final element of the projection system and the substrate. The point of this is to enable imaging of smaller features since the exposure radiation will have a shorter wavelength in the liquid. (The effect of the liquid may also be regarded as increasing the effective NA of the system).

However, submersing the substrate or substrate and substrate table in a bath of liquid (see for example US 4,509,852) means that there is a large body of liquid that must be accelerated during a scanning exposure. This requires additional or more powerful motors and turbulence in the liquid may lead to undesirable and unpredictable effects.

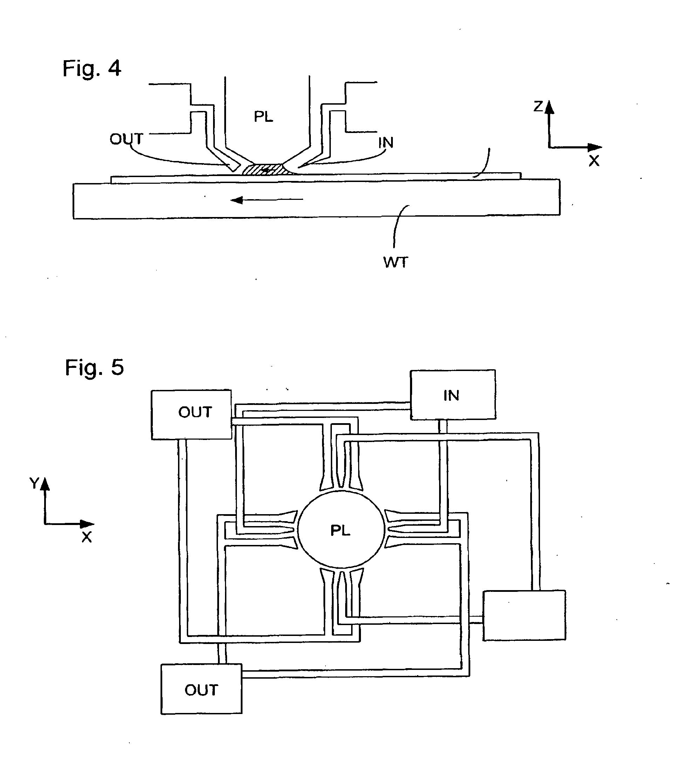

One of the solutions proposed is for a liquid supply system to provide liquid in a localized area between the final element of the projection system and the substrate (the substrate generally has a larger surface area than the final element of the projection systems). One way which has been proposed to arrange for this is disclosed in WO 99/49504. As illustrated in Figures 4 and 5, liquid is supplied by at least one inlet IN onto the substrate, preferably along the direction of movement of the substrate, relative to the final element, and is removed by at least one outlet OUT after having passed under the projection system. That is, as the substrate is scanned beneath the element in a - X direction, liquid is supplied at the +X side of the element and taken up at the -X side. Figure 4 shows the arrangement schematically in which liquid is supplied via inlet IN and is taken up on the other side of the element by outlet OUT which is connected to a low pressure source. In the illustration of Figure 4 the liquid is supplied along the direction of movement of the substrate relative to the final element, though this does not need to be the case. Various orientations and numbers of in and out-lets positioned around the final element are possible, one example is illustrated in Figure 5 in which four sets of an inlet with an outlet on either side are provided in a regular pattern around the final element to form a liquid reservoir.

However, immersion lithography is an embryonic technology and there remain many problems in its practical application. This patent application is concerned in particular with the alignment and leveling of the substrate. Conventionally alignment and leveling is performed with the substrate in the field of view of the projection system (i.e. at an exposure station). However there is not a lot of space for alignment or level measurement apparatus in and around the immersion liquid reservoir so the adaptation is likely to be complex or the accuracy can be compromised. Furthermore, the presence of liquid near the alignment and level measurement apparatus can degrade the performance of the apparatus.

JP 10 340846 discloses a lithographic apparatus in which there is a liquid lens between the projection system and the substrate.

US 6,191,429 B discloses a focusing system in which the focus beam travels through a liquid.

EP1571696A, which is a prior art only by virtue of A54(3) EPC, discloses a lithographic apparatus in which a liquid is supplied between the lower surface of the projection system and the substrate via supply nozzles.

It is an object of the present invention to provide a method and apparatus for accurately aligning and/or leveling a substrate in an immersion lithography apparatus.

This and other objects are achieved according to the invention in a lithographic apparatus as specified in the opening paragraph, characterized in that the measurement system is arranged so as to measure the location of points on said substrate not through said liquid of said liquid supply system. The position of points on the substrate are thus measured outside the immersion system and without the presence of liquid. Alternatively, the measurements could take place while the target portion of the substrate is submerged in liquid, i.e. the measurements take place through liquid, but not the same liquid as supplied by the liquid supply system for filling the space between the final element of the projection system and the substrate. The position of points on the substrate would therefore be measured with liquid between the measurement system and the substrate, the liquid would then be removed before moving the substrate (and substrate table) to the focal point of the projection system where the liquid supply system would supply liquid to fill the space between the final element of the projection system and the substrate prior to exposure taking place. A second liquid supply system may be present in the vicinity of the measurement system.

An advantage of the present invention is that there is better flow in the liquid reservoir because the measurement system is no longer in or around the reservoir crowding the projection system and the performance of the measurement system is not degraded by the presence of liquid. Furthermore smooth flow conditions in the liquid reservoir are preferred as there is no change in the apparatus leading to rough edges. Using this method, measurement systems not specifically adapted for immersion lithography can be used without complex adaptation. A further advantage of this measurement system is that any improvements to such measurement systems used outside of the immersion lithography field can easily and automatically be incorporated into the immersion system.

The measurement system preferably comprises an alignment system for measuring the locations (in the x, y and $R_z$ directions) of a plurality of alignment marks on said substrate. According to an embodiment of the invention said substrate table has a reference and said measurement system measures the location of said reference not through said liquid of said supply system. The location of the alignment marks should preferably be measured relative to said reference on said substrate table to enable a map of alignment marks relative to the reference to be built up.

According to an embodiment of the present invention the measurement system comprises a leveling sensor for measuring the height and/or tilt (i.e. measuring in the z, $R_x$ and $R_y$ directions) of points on said substrate. Thus, level measurement of the substrate, which is conventionally undertaken "on-the-fly" at the exposure station, can be achieved outside the liquid reservoir.

The lithographic projection apparatus can have an exposure station at which said substrate may be exposed and a separate measurement station, said measurement system being provided at said measurement station and said substrate table being movable between said exposure and measurement stations. Furthermore there can be a plurality of substrate tables, each movable between an exposure station and a measurement station. While one substrate table is being mapped, a second substrate table can be exposed. Substrate throughput is therefore higher, the apparatus more efficient and the cost of ownership improved.

According to an embodiment of the invention said reference is a transmission image sensor.

The alignment system preferably measures displacement in two linear perpendicular directions and rotation within the plane defined by the two perpendicular directions.

According to a further aspect of the invention there is provided a device manufacturing method comprising the steps of:

- providing a substrate that is at least partially covered by a layer of radiation-sensitive material on a substrate table, said substrate table having a reference mark;
- measuring the locations of points on said substrate using a measurement beam projected from a measurement system to generate a map of said points on said substrate;
- providing a projection beam of radiation using a radiation system;
- providing a seal member positioned below and surrounding a final element of the projection system, the seal member comprising liquid supply system configured to provide a liquid to fill a space between the substrate and the final element of a projection system used in said step of projecting; using patterning means to endow the projection beam with a pattern in its cross-section;

- projecting the patterned beam of radiation onto a target portion of the layer of radiation-sensitive material,

characterized in that said measurement beam is not projected through said liquid.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet radiation (e.g. with a wavelength of 365, 248, 193, 157 or 126 nm).

Embodiments of the invention will now be described, by way of example only, with reference to the accompanying schematic drawings in which:

Figure 1 depicts a lithographic projection apparatus according to an embodiment of the invention;
Figure 2 depicts a detail of a lithographic projection apparatus according to an embodiment of the invention;
Figure 3 depicts the same details of the lithographic projection apparatus as Figure 2 at a different stage in the exposure process according to an embodiment of the invention;
Figure 4 depicts an alternative liquid supply system according to an embodiment of the invention; and
Figure 5 is an alternative view of the liquid supply system of Figure 4 according to an embodiment of the invention.

In the Figures, corresponding reference symbols indicate corresponding parts.

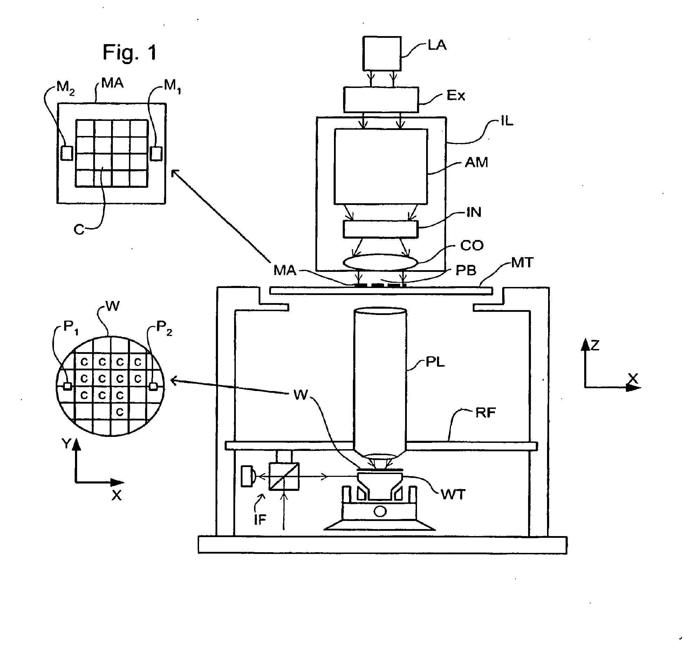

Figure 1 schematically depicts a lithographic projection apparatus according to a particular embodiment of the invention. The apparatus comprises:

a radiation system Ex, IL, for supplying a projection beam PB of radiation (e.g. UV radiation), which in this particular case also comprises a radiation source LA;
a first object table (mask table) MT provided with a mask holder for holding a mask MA (e.g. a reticle), and connected to first positioning means for accurately positioning the mask with respect to item PL;

a second object table (substrate table) WT provided with a substrate holder for holding a substrate W (e.g. a resist-coated silicon wafer), and connected to second positioning means for accurately positioning the substrate with respect to item PL;
a projection system ("lens") PL (e.g. a refractive lens system) for imaging an irradiated portion of the mask MA onto a target portion C (e.g. comprising one or more dies) of the substrate W.

As here depicted, the apparatus is of a transmissive type (e.g. has a transmissive mask). However, in general, it may also be of a reflective type, for example (e.g. with a reflective mask). Alternatively, the apparatus may employ another kind of patterning means, such as a programmable mirror array of a type as referred to above.

The source LA (e.g. a laser-produced or discharge plasma source) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and Claims encompass both of these scenarios.

The beam PB subsequently intercepts the mask MA, which is held on a mask table MT. Having traversed the mask MA, the beam PB passes through the projection system PL, which focuses the beam PB onto a target portion C of the substrate W. With the aid of the second positioning means (and interferometric measuring means IF), the substrate table WT can be moved accurately, e.g. so as to position different target portions C in the path of the beam PB. Similarly, the first positioning means can be used to accurately position the mask MA with respect to the path of the beam PB, e.g. after mechanical retrieval of the mask MA from a mask library, or during a scan. In general, movement of the object tables MT, WT will be realized with the aid of a long-stroke module (course positioning) and a short-stroke module (fine positioning), which are not explicitly depicted in Figure 1. However, in the case of a wafer stepper (as opposed to a step-and-scan apparatus) the mask table MT may just be connected to a short stroke actuator, or may be fixed in the XY plane.

The depicted apparatus can be used in two different modes:

1. In step mode, the mask table MT is kept essentially stationary, and an entire mask image is projected in one go (*i.e.* a single "flash") onto a target portion C. The substrate table WT is then shifted in the x and/or y directions so that a different target portion C can be irradiated by the beam PB;

2. In scan mode, essentially the same scenario applies, except that a given target portion C is not exposed in a single "flash". Instead, the mask table MT is movable in a given direction (the so-called "scan direction", *e.g.* the y direction) with a speed *v*, so that the projection beam PB is caused to scan over a mask image; concurrently, the substrate table WT is simultaneously moved in the same or opposite direction at a speed $V = Mv$, in which M is the magnification of the projection system PL (typically, $M = 1/4$ or 1/5). In this manner, a relatively large target portion C can be exposed, without having to compromise on resolution.

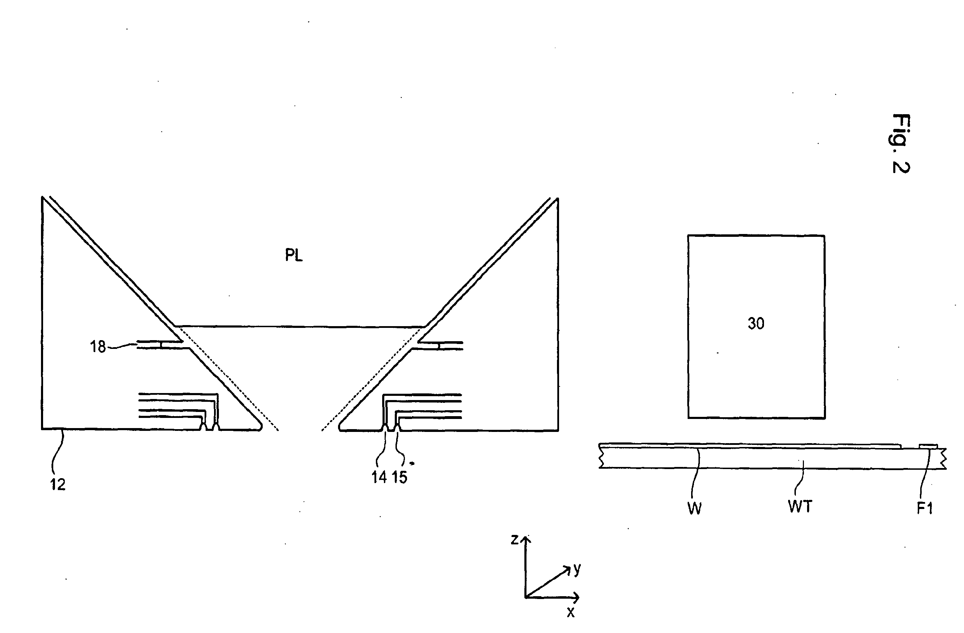

In Figure 2 the substrate table WT is at a measurement station where alignment and/or level measurement take place. The substrate table is provided with a reference F1, sometimes referred to as a fiducial, which can comprise a plate etched through with a pattern corresponding to a standard alignment mark underneath which is a radiation sensor, also known as a transmission image sensor, responsive to radiation. At the measurement station, the substrate table WT is moved to detect the reference F 1 using an alignment system within the measurement system 30 and then to detect the alignment marks on the substrate W thereby enabling the location (in directions x, y and $R_z$) of the substrate alignment marks to be found. In an embodiment, the location of the alignment marks are measured and determined relative to the reference.

Level measurement of the substrate then occurs at the measurement station. In order to measure the level of the substrate, a leveling beam (projected from the measurement system 30) can be used that traverses a first grating prior to reflection by the substrate W. A second grating is then placed in the path of the leveling beam after reflection by the substrate W. The extent to which the images of the first and second gratings coincide is measured by a level measurement sensor and is determined by the height and/or tilts of the substrate W (the z, $R_x$ and $R_y$ coordinates are thus determined). For a further description of level measurement of substrates reference is made to European patent application EP 02,257,251. Hence, using data from the alignment of the substrate and the level measurement of the substrate a map of the substrate can be generated.

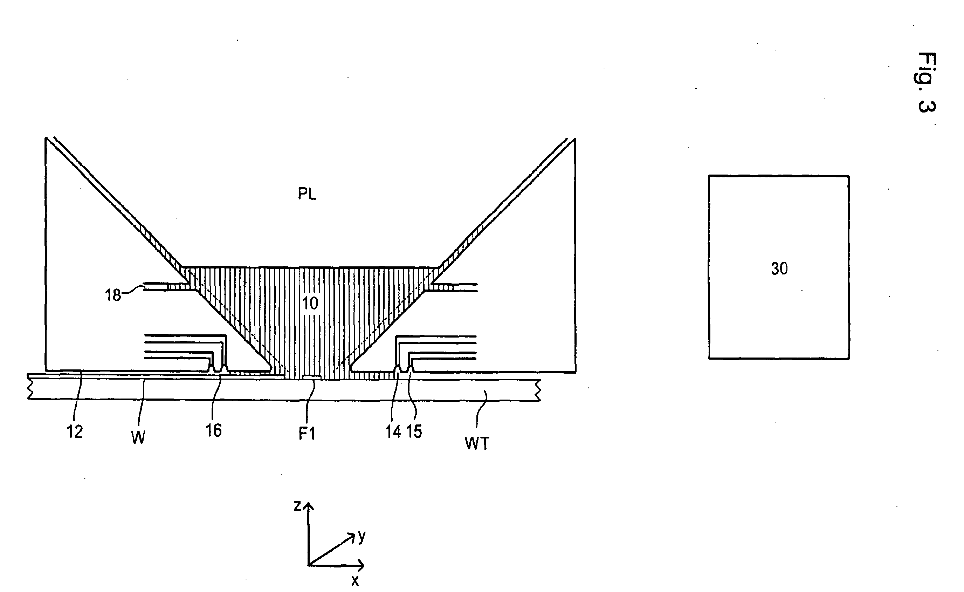

As shown in Figure 3, substrate table WT is then moved to the separate exposure station where liquid supply means 18 are provided to supply liquid (e.g. water) to a space between the projection system PL and the substrate table WT to form a liquid reservoir 10. In this example, the reservoir 10 forms a contactless seal to the substrate around the image field of the projection system PL so that liquid is confined to fill a space between the substrate surface and the final element of the projection system PL. A seal member 12, positioned below and surrounding the final element of the projection system PL, borders the reservoir 10 and comprises the liquid supply means 18. The seal member 12 extends a little above the final element of the projection system and has an inner periphery that at the upper end closely conforms to the step of the projection system or the final element thereof and may, e.g., be round. At the bottom, the inner periphery closely conforms to the shape of the image field, e.g., rectangular though this need not be the case. Liquid is brought into the space below the projection system and within the seal member 12 and the liquid level rises above the final element of the projection system PL so that a buffer of liquid is provided.

A gas seal 16, formed between the bottom of the seal member 12 and the surface of the substrate W, confines the liquid in the reservoir. The gas seal is formed by gas, e.g. air or synthetic air but preferably $N_2$ or another inert gas, provided under pressure via inlet 15 to the gap between seal member 12 and substrate and extracted via first outlet 14. An overpressure on the gas inlet 15, vacuum level on the first outlet 14 and geometry of the gap are arranged so that there is a high-velocity air flow inwards that confines the liquid.

In an embodiment, the liquid reservoir defined by inlet(s) IN and outlet(s) OUT as shown in Figs. 4 and 5 can be similarly applied. In such a case, a measurement station can be provided as well as an exposure station comprising inlet(s) IN and outlet(s) OUT.

To ascertain the exact position of the substrate table WT at the exposure station the reference F1 is scanned in three dimensions through the aerial image of an alignment mark on the mask MA. The maximum signal is returned when the reference is aligned with the image of the mark on the mask in the plane of best focus. Using the map of the substrate W generated at the measurement station the location, height and/or tilt of positions on the substrate W are therefore known. In order to track the movements of the substrate table WT, suitable position measurements devices can be used such as an interferometer beam projected towards one or more sides of the substrate table WT. A particular point on the substrate table can be placed at the focal point of the projection system PL and exposure of a target portion C of the substrate W can take place.

Once exposure of the substrate W is completed it is then removed for further processing and a new substrate placed on substrate table WT. The substrate table with the new substrate returns to the measurement station and the process can be repeated.

Prior to the substrate table WT leaving the exposure station, the liquid reservoir can be emptied, for example in the case shown in Figs. 2 and 3, by reducing the gas inlet pressure and allowing the liquid to be sucked out by the vacuum system or, for example in the case shown in Figs. 4 and 5, by discontinuing flow of liquid onto the substrate through inlet IN and allowing the liquid to be sucked out by outlet OUT.

To ascertain the exact position of the substrate table WT the position of the transmission image sensor described above can be sensed through the liquid, or alternatively not through the liquid and a correction applied.

According to an embodiment of the invention there are at least two substrate tables, each bearing a reference, and while one substrate table is at the measurement station the other is at the exposure station. The substrate tables are movable between an exposure station and a measurement station.

Instead of using the reference mark F1 and the projection system to align the substrate, off-axis measurement can be used. The reference mark F 1 can be aligned using another system near the projection system PL. Alternatively, a different reference and a different system, for example one with an axis perpendicular to the projection axis of the projection system can be used. Further description of such off-axis measurement can be found in EP-A-0,906,590.

Alternatively, if the substrate table is above the projection system (i.e. the projection system is upside down compared to Figure 1) the liquid in liquid reservoir 10 may not need to be completely removed and could just be refilled as necessary.

In an alternative embodiment detection there is no separate measurement station. Detection and measurement of the alignment mark takes place at the exposure station but with no liquid in reservoir 10. The liquid reservoir 10 is then filled up and exposure takes place. Similarly level measurement can take place at the exposure station with no liquid in reservoir 10. These measurements can be either off-axis or on-axis.

Whilst specific embodiments of the invention have been described above, it will be appreciated that the invention may be practiced otherwise than as described. The description is not intended to limit the invention.

**Claims**

1. A lithographic projection apparatus comprising:

   - a radiation system (LA) for providing a projection beam (PB) of radiation;
   - a support structure (MT) for supporting patterning means (MA), the patterning means serving to pattern the projection beam according to a desired pattern;
   - a substrate table (WT) for holding a substrate (W);
   - a projection system (PL) for projecting the patterned beam onto a target portion of the substrate;
   - a seal member (12) positioned below and surrounding a final element of the projection system (PL), the seal member (12) comprising a liquid supply system (18) for filling a space between the final element of said projection system and said substrate with a liquid; and
   - a measurement system (30) for measuring locations of points on said substrate and generating a map of said points on said substrate,

   **characterized in that** said measurement system (30) is arranged so as to measure the location of points on said substrate (W) not through said liquid of said liquid supply system.

2. A lithographic projection apparatus according to claim 1 wherein the measurement system comprises an alignment system for measuring the locations of a plurality of alignment marks on said substrate (W).

3. A lithographic projection apparatus according to either claim 1 or claim 2 wherein said substrate table (WT) has a reference and said measurement system (30) measures the location of said reference not through said liquid of said liquid supply system.

4. A lithographic projection apparatus according to claim 3 wherein said measurement system (30) measures and determines the location of a plurality of said alignment marks on said substrate (W) relative to said reference on said substrate table.

5. A lithographic projection apparatus according to any one of the preceding claims wherein said measurement system (30) comprises a leveling sensor for measuring the height and/or tilt of points on said substrate (W).

6. A lithographic projection apparatus according to any one of the preceding claims having an exposure station at which said substrate may be exposed and a separate measurement station, said measurement system (30) being provided at said measurement station and said substrate table (WT) being movable between said exposure and measurement stations.

7. A lithographic projection apparatus according to claim 6 wherein there are a plurality of substrate tables (WT), each movable between an exposure station and a measurement station.

8. A lithographic projection apparatus according to any one of the preceding claims wherein said reference is a transmission image sensor.

9. A device manufacturing method comprising the steps of:

   - providing a substrate (W) that is at least partially covered by a layer of radiation-sensitive material on a substrate table (WT), said substrate table having a reference mark;
   - measuring the locations of points on said substrate using a measurement beam projected from a measurement system to generate a map of said points on said substrate;
   - providing a projection beam (PB) of radiation using a radiation system;
   - providing a seal member (12) positioned below and surrounding a final element of the projection system (PL), the seal member comprising a liquid supply system configured to provide a liquid to fill a space between the substrate and the final element of a projection system (PL) used in said step of projecting;
   - using patterning means to endow the projection beam with a pattern in its cross-section;
   - projecting the patterned beam of radiation onto a target portion of the layer of radiation-sensitive material,

   **characterized in that** said measurement beam is not projected through said liquid.

10. A device manufacturing method according to claim 9 wherein measuring the locations comprises measuring the locations of alignment marks on said substrate (W).

11. A device manufacturing method according to either claim 9 or claim 10 wherein measuring the locations comprises measuring the height and/or tilts of points on said substrate (W).

**Patentansprüche**

1. Ein lithographisches Projektionsgerät, das Folgendes beinhaltet:

   - ein Strahlungssystem (LA) zum Bereitstellen eines Projektionsstrahls (PB) aus Strahlung;
   - eine Stützstruktur (MT) zum Stützen eines Musteraufbringungsmittels (MA), wobei das Musteraufbringungsmittel dazu dient, den Projektionsstrahl gemäß einem gewünschten Muster zu mustern;
   - einen Substrattisch (WT) zum Halten eines Substrats (W);
   - ein Projektionssystem (PL) zum Projizieren des gemusterten Strahls auf einen Zielabschnitt des Substrats;
   - ein Abdichtungselement (12), das unterhalb einer Endkomponente des Projektionssystems (PL) positioniert ist und diese umgibt, wobei das Abdichtungselement (12) ein Flüssigkeitszufuhrsystem (18) zum Füllen eines Raums zwischen der Endkomponente des Projektionssystems und dem Substrat mit einer Flüssigkeit beinhaltet; und
   - ein Messsystem (30) zum Messen von Lagen von Punkten auf dem Substrat und Erzeugen einer Abbildung der Punkte auf dem Substrat,

   **dadurch gekennzeichnet, dass** das Messsystem (30) eingerichtet ist, um die Lage von Punkten auf dem Substrat (W) nicht durch die Flüssigkeit des Flüssigkeitszufuhrsystems zu messen.

2. Lithographisches Projektionsgerät gemäß Anspruch 1, wobei das Messsystem ein Justiersystem zum Messen der Lagen einer Vielzahl von Justiermarken auf dem Substrat (W) beinhaltet.

3. Lithographisches Projektionsgerät gemäß entweder Anspruch 1 oder Anspruch 2, wobei der Substrattisch (WT) einen Bezugspunkt aufweist und das Messsystem (30) die Lage des Bezugspunktes nicht durch die Flüssigkeit des Flüssigkeitszufuhrsystems misst.

4. Lithographisches Projektionsgerät gemäß Anspruch 3, wobei das Messsystem (30) die Lage einer Vielzahl der Justiermarken auf dem Substrat (W) relativ zu dem Bezugspunkt auf dem Substrattisch misst und bestimmt.

5. Lithographisches Projektionsgerät gemäß einem der vorhergehenden Ansprüche, wobei das Messsystem (30) einen Nivellierungssensor zum Messen der Höhe und/oder Neigung von Punkten auf dem Substrat (W) beinhaltet.

6. Lithographisches Projektionsgerät gemäß einem der vorhergehenden Ansprüche, das eine Belichtungsstation, an der das Substrat belichtet werden kann, und eine separate Messstation aufweist, wobei das Messsystem (30) an der Messstation bereitgestellt ist und der Substrattisch (WT) zwischen der Belichtungs- und der Messstation bewegbar ist.

7. Lithographisches Projektionsgerät gemäß Anspruch 6, wobei es eine Vielzahl von Substrattischen (WT) gibt, die jeweils zwischen einer Belichtungsstation und einer Messstation bewegbar sind.

8. Lithographisches Projektionsgerät gemäß einem der vorhergehenden Ansprüche, wobei der Bezugspunkt ein Transmissionsbildsensor ist.

9. Ein Verfahren zum Herstellen einer Vorrichtung, das die folgenden Schritte beinhaltet:

- Bereitstellen eines Substrats (W), das mindestens teilweise von einer Schicht aus strahlungsempfindlichem Material bedeckt ist, auf einem Substrattisch (WT), wobei der Substrattisch eine Bezugsmarke aufweist;
- Messen der Lagen von Punkten auf dem Substrat unter Verwendung eines Messstrahls, der von einem Messsystem projiziert wird, zum Erzeugen einer Abbildung der Punkte auf dem Substrat;
- Bereitstellen eines Projektionsstrahls (PB) aus Strahlung unter Verwendung eines Strahlungssystems;
- Bereitstellen eines Abdichtungselements (12), das unterhalb einer Endkomponente des Projektionssystems (PL) positioniert ist und diese umgibt, wobei das Abdichtungselement ein Flüssigkeitszufuhrsystem beinhaltet, das konfiguriert ist, um eine Flüssigkeit zum Füllen eines Raums zwischen dem Substrat und der Endkomponente eines in dem Projizierschritt verwendeten Projektionssystems (PL) bereitzustellen;
- Verwenden eines Musteraufbringungsmittels, um den Projektionsstrahl in seinem Querschnitt mit einem Muster zu versehen;
- Projizieren des gemusterten Strahls aus Strahlung auf einen Zielabschnitt der Schicht aus strahlungsempfindlichem Material,

**dadurch gekennzeichnet, dass** der Messstrahl nicht durch die Flüssigkeit projiziert wird.

10. Verfahren zum Herstellen einer Vorrichtung gemäß Anspruch 9, wobei das Messen der Lagen das Messen der Lagen von Justiermarken auf dem Substrat (W) beinhaltet.

11. Verfahren zum Herstellen einer Vorrichtung gemäß entweder Anspruch 9 oder Anspruch 10, wobei das Messen der Lagen das Messen der Höhe und/oder Neigungen von Punkten auf dem Substrat (W) beinhaltet.

**Revendications**

1. Un appareil de projection lithographique comprenant :

- un système de rayonnement (LA) destiné à fournir un faisceau de projection (PB) de rayonnement ;
- une structure formant support (MT) destinée à supporter un moyen pour conformer selon un motif (MA), le moyen pour conformer selon un motif servant à conformer le faisceau de projection selon un motif souhaité ;
- une table porte-substrat (WT) destinée à porter un substrat (W) ;
- un système de projection (PL) destiné à projeter le faisceau à motif sur une portion cible du substrat ;
- un élément d'étanchéité (12) positionné sous et entourant un organe final du système de projection (PL), l'élément d'étanchéité (12) comprenant un système d'alimentation en liquide (18) destiné à remplir un espace entre l'organe final dudit système de projection et ledit substrat avec un liquide ; et
- un système de mesure (30) destiné à mesurer des emplacements de points sur ledit substrat et à générer une carte desdits points sur ledit substrat,

**caractérisé en ce que** ledit système de mesure (30) est arrangé de manière à mesurer l'emplacement de points sur ledit substrat (W) non à travers ledit liquide dudit système d'alimentation en liquide.

2. Un appareil de projection lithographique selon la revendication 1 dans lequel le système de mesure comprend un système d'alignement destiné à mesurer les emplacements d'une pluralité de repères d'alignement sur ledit substrat (W).

3. Un appareil de projection lithographique selon soit la revendication 1, soit la revendication 2 dans lequel ladite table porte-substrat (WT) présente une référence et ledit système de mesure (30) mesure l'emplacement de ladite référence non à travers ledit liquide dudit système d'alimentation en liquide.

4. Un appareil de projection lithographique selon la revendication 3 dans lequel ledit système de mesure (30) mesure et détermine l'emplacement d'une pluralité de dits repères d'alignement sur ledit substrat (W) relativement à ladite référence sur ladite table porte-substrat.

5. Un appareil de projection lithographique selon l'une quelconque des revendications précédentes dans lequel ledit système de mesure (30) comprend un capteur de nivellement destiné à mesurer la hauteur et/ou l'inclinaison de points sur ledit substrat (W).

6. Un appareil de projection lithographique selon l'une quelconque des revendications précédentes présentant un poste d'exposition au niveau duquel ledit substrat peut être exposé et un poste de mesure distinct, ledit système de mesure (30) étant fourni au niveau dudit poste de mesure et ladite table porte-substrat (WT) étant déplaçable entre lesdits postes d'exposition et de mesure.

**7.** Un appareil de projection lithographique selon la revendication 6 dans lequel il y a une pluralité de tables porte-substrat (WT), chacune déplaçable entre un poste d'exposition et un poste de mesure.

**8.** Un appareil de projection lithographique selon l'une quelconque des revendications précédentes dans lequel ladite référence est un capteur d'image de transmission.

**9.** Un procédé de fabrication de dispositif comprenant les étapes consistant à :

- fournir un substrat (W) qui est au moins partiellement recouvert d'une couche de matériau sensible à un rayonnement sur une table porte-substrat (WT), ladite table porte-substrat présentant un repère de référence ;
- mesurer les emplacements de points sur ledit substrat à l'aide d'un faisceau de mesure projeté depuis un système de mesure afin de générer une carte desdits points sur ledit substrat ;
- fournir un faisceau de projection (PB) de rayonnement à l'aide d'un système de rayonnement ;
- fournir un élément d'étanchéité (12) positionné sous et entourant un organe final du système de projection (PL), l'élément d'étanchéité comprenant un système d'alimentation en liquide configuré afin de fournir un liquide pour remplir un espace entre le substrat et l'organe final d'un système de projection (PL) utilisé dans ladite étape de projection ;
- utiliser un moyen pour conformer selon un motif afin de doter le faisceau de projection d'un motif dans sa coupe transversale ;
- projeter le faisceau de rayonnement à motif sur une portion cible de la couche de matériau sensible au rayonnement,

**caractérisé en ce que** ledit faisceau de mesure n'est pas projeté à travers ledit liquide.

**10.** Un procédé de fabrication de dispositif selon la revendication 9 dans lequel le fait de mesurer les emplacements comprend le fait de mesurer les emplacements de repères d'alignement sur ledit substrat (W).

**11.** Un procédé de fabrication de dispositif selon soit la revendication 9, soit la revendication 10 dans lequel le fait de mesurer les emplacements comprend le fait de mesurer la hauteur et/ou les inclinaisons de points sur ledit substrat (W).

Fig. 1

Fig. 2

Fig. 3

Fig. 4

Fig. 5

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5296891 A
- US 5523193 A
- WO 9838597 A
- WO 9833096 A
- US 5229872 A
- US 6046792 A
- US 5969441 A
- WO 9840791 A

- US 4509852 A
- WO 9949504 A
- JP 10340846 A
- US 6191429 B
- EP 1571696 A
- EP 02257251 A
- EP 0906590 A

**Non-patent literature cited in the description**

- **PETER VAN ZANT.** Microchip Fabrication: A Practical Guide to Semiconductor Processing. McGraw Hill Publishing Co, 1997